(19) European Patent Office
Europäisches Patentamt
Office européen des brevets

(11) **EP 0 974 888 A1**

(12) **EUROPEAN PATENT APPLICATION**

(43) Date of publication:
26.01.2000 Bulletin 2000/04

(51) Int. Cl.⁷: **G06E 1/02**

(21) Application number: 99202313.5

(22) Date of filing: 14.07.1999

(84) Designated Contracting States:
**AT BE CH CY DE DK ES FI FR GB GR IE IT LI LU MC NL PT SE**
Designated Extension States:
**AL LT LV MK RO SI**

(30) Priority: 18.07.1998 EP 98202411

(71) Applicant:
**PIRELLI CAVI E SISTEMI S.p.A.**
**20126 Milano (IT)**

(72) Inventors:
• **Boffi, Pierpaolo**
**27058 Voghera (Pavia) (IT)**

• **Martinelli, Mario**
**20097 S. Donato Milanese (Milano) (IT)**
• **Piccinin, Davide**
**20132 Milano (IT)**
• **Ubaldi, Maria Chiara**
**20121 Milano (IT)**

(74) Representative:
**Marchi, Massimo et al**
**c/o Marchi & Partners s.r.l.,**
**Via Pirelli, 19**
**20124 Milano (IT)**

(54) **Optical device for processing a predetermined N-bits optical sequence**

(57) An optical device (6) for processing an input optical serial sequence (1000) of phase-modulated N-bits having a predetermined one-bit time slot in order to compare said input optical serial sequence (1000) of phase-modulated N-bits with a predetermined sequence of N-bits, said device comprising

a) input means (64) for said input optical serial sequence (1000) of phase-modulated N-bits;
b) a first optical element (61; 701) for converting said input optical serial sequence (1000) of phase-modulated N-bits into an optical parallel pattern (3000) of phase-modulated N-bits carrying the same information as said input optical serial sequence (1000) of phase-modulated N-bits;
c) a second optical element (616; 619; 62; 704) capable of causing a phase delay of at least one bit of said optical parallel pattern (3000), said phase delay having a preselected value depending on said predetermined N-bits sequence.

EP 0 974 888 A1

## Description

The present invention relates to an optical device, a transmission system and a method for processing an optical serial sequence of N-bits. More particularly, the present invention relates to an optical device for comparing an optical serial sequence of N-bits with a predetermined sequence of N-bits.

An opto-electronic device for processing a predetermined N-bits optical sequence is known by Killat U. et al. ["Data word recognition in fibre optic systems", NTG-Fachberichte, vol. 75, p. 213-220, (1980)] who disclose the principle and performance of a system to recognize a 13-bits word in a data stream consisting of a series of optical fiber delay lines connected in a particular way to two opto-electronic detectors. The difference of outputs from said opto-electronic detectors gives a sharp peak when the test word is present.

Nevertheless, opto-electronic detectors show the known drawbacks of electronics which is going to become a bollleneck in optical communication systems and networks. In fact, electronic apparatuses have a narrow bandwidth compared to the optical bandwidth available in fiber optical communication systems and are usually based on serial data processing.

The employment of optics in data processing is being studied to overcome these limitations. Potentially, processing apparatuses based on optical technology have a larger bandwidth and are transparent to data bit-rate, data format and transmission encoding. Additional advantages of optics versus electronics are, for example, electromagnetic interference immunity, low skew, absence of impedance-matching problems.

Optical devices are known for processing a predetermined N-bits optical sequence.

WO 93/14604 discloses an optical code recognition unit (OCRU) for recognizing a predetermined n-bit optical code having an n-way splitter with an input and n parallel outputs. A plurality of combiners are associated with the splitter outputs, and a respective gate is controlled by the output of each of the combiners. Each of the splitter outputs is subjected to a different delay of from 0 to (n-1) bit periods, and each combiner receives an input from at least one of the splitter outputs. The OCRU is such that all the gates are turned on if a predetermined optical code is applied to the splitter input.

US Patent No. 5,446,571 discloses an optical code recognition unit (OCRU) for recognizing a predetermined n-bit optical code sequence coded using the Manchester code format, having an n-way splitter with an input and n parallel outputs. A plurality of gates are associated with the splitter outputs, respective pairs of splitter outputs leading to each of the gates via a respective optical combiner, and any remaining single splitter output leading directly to its gate. Each of the splitter outputs is subjected to a different delay of m half bit periods, where m=0 to 2(n-1), the value of m being chosen such that, if a predetermined optical code sequence is applied to the splitter input, the "1"s in the outputs of each of the pairs of splitter outputs reach the associated AND gates and the "1" in any remaining single splitter output reaches its AND gate at predetermined times such that all the gates are turned on.

However, the above mentioned disclosures relate to synchronous optical signal processing.

The present invention aims at exploiting the above mentioned advantages offered by optics with an optical device and a method for performing an asynchronous parallel processing of a N-bits optical serial sequence.

Asynchronous optical devices are known for recognizing input images, objects or patterns by means of optical correlation.

Homer J. L. et at. ["Phase-only matched filtering", Applied Optics, vol. 23, No. 6, p. 812-816, (1984)] disclose a comparison between the phase-only and amplitude-only filters to the classical matched filter using the criteria of discrimination, correlation peak, and optical efficiency. They examine the relationship between phase and amplitude in the case of alphanumeric characters, with and without noise, using a computer simulation.

US 5 073 006 discloses a compact 2f optical correlator using two single element lenses, with the second lens performing both quadratic phase term removal and the inverse Fourier transform operation in a compact two-focal-length space.

Fielding K. H. et al. ["1-f binary joint transform correlator", Optical Engineering, Vol. 29, No. 9, p. 1083-1087, (1990)] disclose a one lens focal length binary joint transform correlator having a magneto-optical spatial light modulator, lens and standard 8-bits resolution CCD camera.

Davis J. A. et at. ["Space-variant Fresnel transform optical correlator", Applied Optics, vol. 31, No. 32, p. 6889-6893, (1992)] disclose a space-variant optical correlator whose output depends on both the shape and the position of the input signal. Said positionally sensitive correlator has potential applications in machine vision, cryptography, and optical logic.

US 5 214 534 disclose a method for performing image correlation in a Fourier transform correlator comprising the steps of: a) inputting an input image signal into the Fourier transform correlator; b) phase encoding said input image into a first phase-only encoded signal; c) providing a second phase-only encoded reference filter image signal; d) producing the Fourier transform of the first phase-only encoded signal; and e) inverse Fourier transforming the product of the Fourier transform of the first phase-only encoded signal and second phase-only encoded reference filter image to obtain a correlation signal.

Claire G. et al. ["Correlation patterns and cross-talk noise in volume holographic optical correlators", Optical Society of America, vol. 12, No. 5, p. 861-868 (1995)1 describe a theoretical study of the correlation pattern and the cross-talk noise of optical correlators using multiplexed volume holograms as matched filters.

Hamam H. et al. ["Fresnel transform-based correlator", Applied Optics, vol. 36, No. 29, p. 7408-7414, (1997)] disclose a technique for information processing using Fresnel transform-based correlation and the design of a correlator involving the reference object and its near-field diffraction pattern at an optimized distance. The input-scene image and its diffraction pattern constitute the input pattern of the correlator.

However, the issue of optical serial sequence of N-bits (digital word) recognition, that is the capability to discriminate a predetermined serial sequence of N-bits (target digital word) from every other one, also if the difference is of one bit only, is very different from that one of image recognition wherein different images generally differ far more than for one point only.

In one aspect, the present invention aims at providing an optical asynchronous device for processing optical serial sequences of N-bits in order to compare an optical serial sequence of N-bits with a target one.

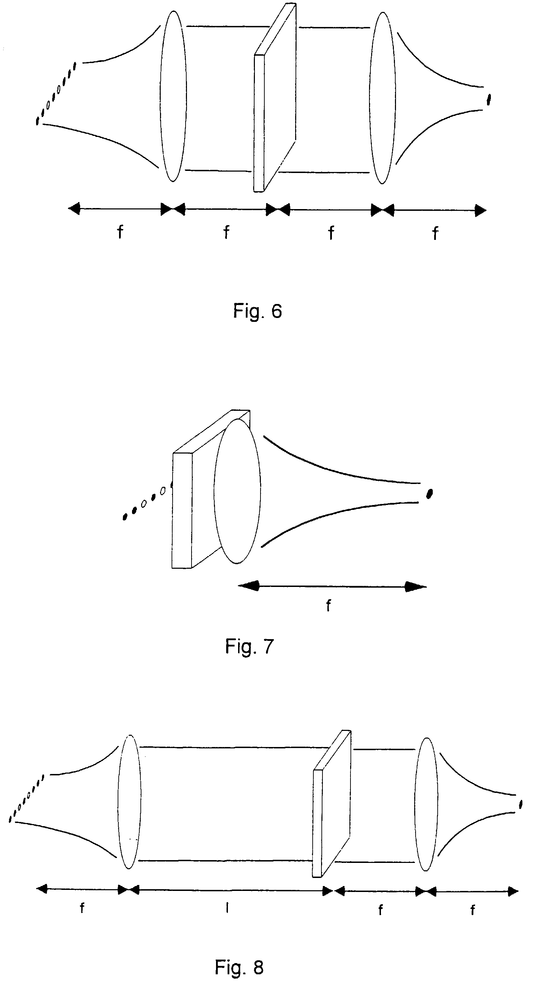

The inventors tried to use the conventional Vander Lugt optical correlator which is known in pattern (i.e. image) processing techniques. This device comprises a first optical convex lens, a second optical convex lens and a filter placed on the back focal plane of the first lens and on the front focal plane of the second lens (Fig. 6). Such correlator performs, at the back focal plane of the second lens, an optical correlation between an input image, placed on the front focal plane of the first lens, and a predetermined image suitably recorded on the filter.

Working with a Vander Lugt optical correlator (also known as 4f correlator), the inventors perceived that it was important to investigate two parameters for performing a binary N-bits optical serial sequence recognition: the bit coding (amplitude or phase modulation) and the filter type (matched or phase only). However, the combination of amplitude modulation (AM) with a conventional matched filter (MF) did not allow to discriminate sequences differing from the target one (to be recognized) for the bits where the target sequence had zeros. In this case the discrimination capability was zero for any sequence except for the one where each bit was equal to 1.

Moreover, a phase only filter (POF) together with AM input was able to discriminate only some specific bytes. In case of 8 bits sequences, the maximum discrimination value was found to be D=21.97%, wherein D is defined as:

$$D = 1 - \frac{|c_{MAX}(0,0)|^2}{|a(0,0)|^2}$$

where $|a(0,0)|^2$ is the auto correlation intensity (i.e. the output optical intensity of the correlator with the target sequence in input) and $|c_{MAX}(0,0)|^2$ is the greatest cross-correlation intensity (i.e. the output optical intensity of the correlator with an input sequence which is the most similar to the target one).

By contrast, the introduction of phase modulation (PM) of the input bits increased performances. However, it was not possible to recognize the sequence complementary (with ones and zeros inverted) to the target one. In fact, with MF and PM signals, 4f correlator reached the maximum performance (D=43.75% for 8 bits sequences) with any target sequence except the complementary one. Instead, with input PM bits and POF, 4f correlator had different discrimination capabilities with respect to the target sequence going, in case of 8 bit sequences, from values of 6.1% to 36.65% except for the complementary sequence.

Accordingly, the best discrimination performance of a Vander Lugt correlator for optical sequences was achieved with PM bits and MF. However, the MF implementation is difficult and involves holographic techniques while a POF would be simpler to implement.

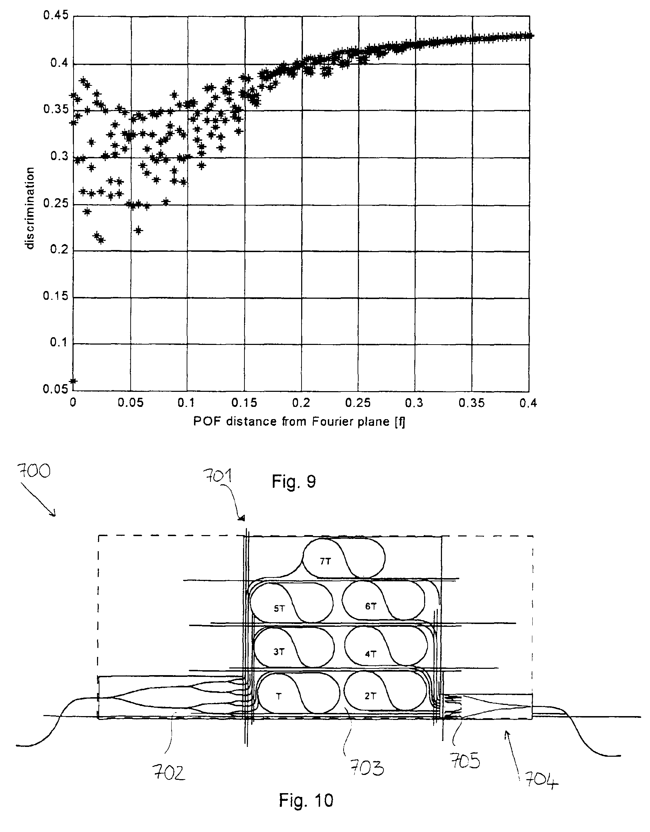

While investigating the performances of a Vander Lugt optical correlator having PM bits and POF, the inventors unexpectedly found that the discrimination value D tended to a maximum constant value as both the POF and the second lens were progressively moved together from the back focal plane f of the first lens (Fig. 8). In Fig. 9 there are plotted some discrimination values D of the correlator shown in Fig. 8 having input PM sequences of 8 bits (bytes) and a POF placed at various different distances from the back focal plane of the first lens (0 distance) up to a 0.4*f distance therefrom (at each different distance the POF was adjusted to implement a phase delay according to the conjugate phase of the 8 bits at its input). At 0.4*f distance, the correlator was found to achieve the maximum discrimination value (about 43.75%) for each byte. At this point, the inventors unexpectedly found also that the discrimination capability value D achieved the maximum discrimination value (43.75%) for each sequence when the POF was located just in front of the second lens, both of them were placed just at the input of the correlator (Fig. 7) and the first lens was taken off. The discrimination capability, thus achieved, was the same as for Vander Lugt correlator having PM bits and MF.

Finally, the inventors perceived that the relevant factor is a predetermined phase delay on the bits entering the device.

It is therefore a first aspect of this invention to provide an optical device for processing an input optical serial sequence of phase-modulated N-bits having a predetermined one-bit time slot in order to compare said input optical serial sequence of phase-modulated N-bits with a predetermined sequence of N-bits, said device comprising

a) input means for said input optical serial sequence of phase-modulated N-bits;
b) a first optical element for converting said input optical serial sequence of phase-modulated N-bits into an optical parallel pattern of phase-modulated N-bits carrying the same information as said input optical serial sequence of phase-modulated N-bits;
c) a second optical element capable of causing a phase delay of at least one bit of said optical parallel pattern, said phase delay having a preselected value depending on said predetermined N-bits sequence.

Preferably, said second optical element causes said phase delay having said preselected value so as to:

- adjust the phase of said at least one bit of said optical parallel pattern according to the conjugate phase of the corresponding bit of said predetermined sequence of N-bits; and
- process the N-bits of said optical parallel pattern substantially in accordance with a Fourier transformation.

More preferably, said second optical element is asynchronous.
According to a first embodiment, said second optical element is a spatial light modulator.
According to a second embodiment, said second optical element is a phase mask.
According to a third embodiment, said second optical element is a waveguide having a predetermined portion with a refractive index which may be suitably modulated so as to perform on said at least one bit of said optical parallel pattern said phase delay.
According to a fourth embodiment, said second optical element adjusts the phase of said at least one bit of said optical parallel pattern according to the conjugate phase of the corresponding bit of said predetermined sequence of N-bits and said optical device further comprises a third optical element for processing the N-bits of said optical parallel pattern substantially in accordance with a Fourier transformation.
Typically, said third optical element consists of an optical lens having a preselected focal length and said second optical element is a phase-only filter.
Preferably, the distance between said second optical element and said third optical element is lower than the focal length of said optical lens. More preferably, said second optical element is placed substantially contiguous to said first optical element.
Furthermore, the optical device further comprises output means for an output optical signal having an intensity level depending on the result of the comparison between said input optical serial sequence of phase-modulated N-bits and said predetermined sequence of N-bits.
Preferably, said output means and said input means comprise an optical waveguide.
According to an embodiment, said first optical element comprises a 1xN beam splitter to clone said input serial sequence of N-bits into N equal replica signals. Preferably, said first optical element further comprises a plurality of optical delay lines having selected lengths for delaying each of said N replica signals according to a predetermined time slot.
According to an other embodiment said first optical element comprises a glass slab.
It is a second aspect of this invention to provide an optical telecommunication system comprising:

- a first apparatus for transmitting at least one optical digital signal comprising at least one optical serial sequence of N-bits,
- an optical transmission line,
- a second apparatus for receiving said at least one optical serial sequence of N-bits,
- a processing module capable of transmitting a result of said comparison,

said second apparatus comprising at least one optical device which, in turn, comprises

i. a first optical element for converting said at least one optical serial sequence of N-bits into an optical parallel pattern of N-bits carrying the same information as said at least one optical serial sequence of N-bits; and
ii. a second optical element capable of causing a phase delay on at least one bit of said at least one optical serial sequence, said phase delay having a preselected value depending on a predetermined sequence of N-bits so as to compare said at least one optical serial sequence of N-bits with said predetermined sequence of N-bits.

Preferably, said first apparatus comprises a phase modulator for phase modulating said at least one optical serial sequence of N-bits.

More preferably, said preselected value of said phase delay caused by said second optical element is selected so as to:

- adjust the phase of said at least one bit of said optical parallel pattern (3000) according to the conjugate phase of the corresponding bit of said predetermined sequence of N-bits; and
- process the N-bits of said optical parallel pattern (3000) substantially in accordance with a Fourier transformation.

Typically, said processing module comprises a photo-detector and a threshold circuit.

According to an embodiment, said second apparatus comprises M optical devices for comparing said at least one serial sequence of N-bits with M predetermined serial sequences of N-bits.

According to an other embodiment said first apparatus transmits a plurality of optical digital signals, each having a predetermined wavelength and consisting of at least one serial sequence of N-bits.

Preferably, said second apparatus comprises at least one optical device for each of said plurality of optical digital signals for comparing each of said at least one serial sequence of N-bits with a predetermined serial sequence of N-bits.

Typically, said optical transmission line is an optical cable.

It is a third aspect of this invention to provide a method for optically comparing an optical serial sequence of phase modulated N-bits with a predetermined sequence of N-bits comprising the steps of:

a) converting said optical serial sequence of phase modulated N-bits into an optical parallel pattern of phase modulated N-bits carrying the same information as said optical serial sequence of N-bits;

b) delaying the phase of at least one bit of said optical parallel pattern of phase modulated N-bits according to a phase delay having a preselected value depending on said predetermined sequence of N-bits.

Preferably, the step b) is performed by:

i. adjusting the phase of at least one bit of said optical parallel pattern of N-bits according to the conjugate phase of the corresponding bit of said predetermined sequence of N-bits; and

ii. processing the N-bits of said optical parallel pattern substantially in accordance with a Fourier transformation.

Typically, the method further comprises the step c) of outputting an output optical signal having an intensity level depending on the result of the comparison between said input optical serial sequence of phase-modulated N-bits and said predetermined sequence of N-bits.

Preferably, the method further comprises the step d) of processing said output optical signal for transmitting a result of the comparison between said optical serial sequence of N-bits and said predetermined sequence of N-bits.

Typically, the step d) comprises a comparison of the intensity of said output optical signal with a predetermined threshold intensity.

Preferably, the step b) is performed asynchronously.

Further advantages of the optical device according to the present invention consist in the fact that the device

- enables processing of an optical signal maintaining the said signal in optical form;
- enables processing of an optical signal in parallel;
- avoids bit rate limitations; and
- is more compact and easier to implement compared to conventional optical devices.

The invention will now become more evident from the following description and the enclosed drawings, having the aim of describing and showing some preferred embodiments without, however, limiting it in any way.

- Fig. 1 is a schematic diagram of an optical device according to a first embodiment of the present invention;
- Fig. 2 is a schematic diagram of a first embodiment of an optical transmission system using the device of Fig. 1;
- Fig. 3 is a schematic diagram of a second embodiment of an optical transmission system using the device of Fig. 1;
- Fig. 4 is a schematic diagram of a first embodiment of a serial to parallel converter in the device of Fig. 1;
- Fig. 5 is a schematic diagram of a second embodiment of a serial to parallel converter in the device of Fig. 1;
- Fig. 6 is a schematic diagram of a conventional Vander Lugt correlator;
- Fig. 7 is a schematic diagram of an input parallel pattern of N-bits entering an optical filter and an optical lens according to the device of Fig. 1;
- Fig. 8 is a schematic diagram of the Vander Lugt correlator of Fig. 6 as modified by the inventors while investigating its performances;

- Fig. 9 is a plot of some discrimination values D of the modified correlator of Fig. 8 when a phase-only filter (POF) is placed at various different distances from the back focal plane of the first lens (0 distance) up to a 0.4*f distance therefrom;

- Fig. 10 is a schematic diagram of an optical device according to a further embodiment of the present invention.

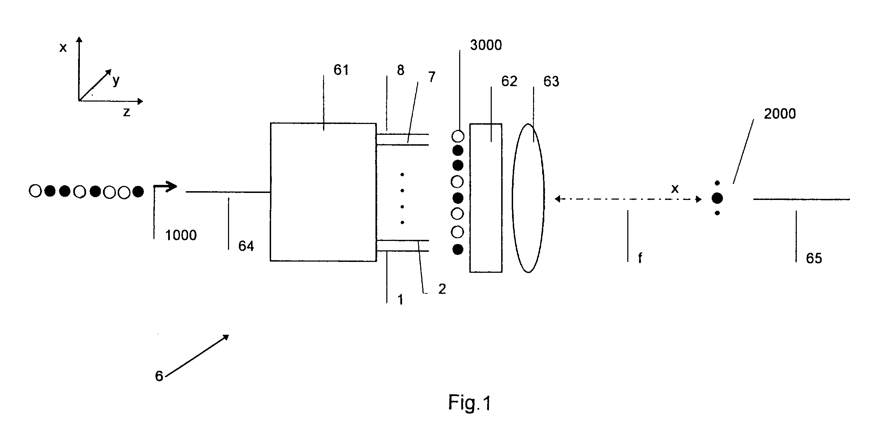

As shown in Fig. 1, an optical device 6 according to a first embodiment of the invention for recognizing a predetermined (target) N-bits optical sequence comprises an input optical waveguide 64, a serial to parallel converter 61, an optical filter 62, an optical lens 63 and an output optical waveguide 65. Said optical filter 62 is placed both at the output of said serial to parallel converter 61 and just in front of said optical lens 63 while said output optical waveguide 65 is placed at a predetermined distance from the focus of said optical lens 63.

Said input and output waveguides 64, 65 are, preferably, made of optical fiber which is single mode at the transmission wavelength.

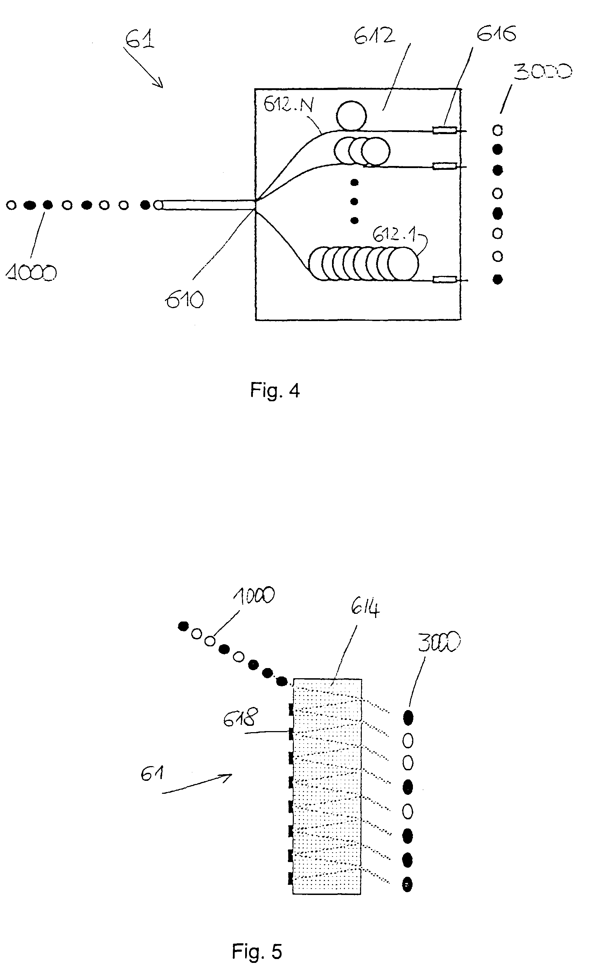

Said serial to parallel converter 61 converts an input optical serial sequence 1000 of binary phase modulated N-bits, in a parallel pattern 3000 of N bits carrying the same information as said serial sequence 1000 of N bits. For example, in Figs.1, 4 and 5, N=8. According to a first embodiment shown in Fig. 4, said converter 61 splits the N-bits serial sequence 1000, issuing from said input waveguide 64, into N equal replica signals and delays the "$i^{th}$" (i=1.......N) replica of a time $\tau_i=(N-i)*T_b$, where $T_b$ is the one-bit time slot, thus producing said parallel pattern 3000 of N-bits.

Preferably, the N-bits optical serial sequence 1000 is splitted by a 1xN beam splitter 610 made, for example, of a single 1xN fused optical fiber coupler (not shown) or more fused optical fiber couplers so as to produce a 1xN beam splitter. For example, for N=8, cascading seven 1x2 fused couplers.

According to a variation, said 1xN beam splitter 610 can also be made by integrated optics or by means of holographic diffraction technology (not shown).

The N replica signals from said beam splitter 610 are delayed by a number of optical delay lines 612 made by suitable lengths of optical fiber or by suitable integrated optic waveguide. To avoid coupling loss between said beam splitter 610 and delay lines 612, an optical fiber delay line is preferably connected to a fused optical fiber coupler while a waveguide delay line is integrated with an optic beam splitter.

According to Fig. 4, the "$i^{th}$" replica signal from said 1xN beam splitter 610 is connected to an optical fiber 612.i having a length such as to delay said "$i^{th}$" replica of the time $\tau_i=(N-i)*T_b$, as mentioned above. Thus, issuing from said serial to parallel converter 61, said N-bits parallel patterns 3000 is found.

Preferably, conventional heaters 616, placed either at the output ends of said delay lines 612 or along said delay fibers 612, enable a precise regulation of the phase delay of each of said N replica signals so that among the N-bits of said parallel patterns 3000 there is the same phase relationship as among the N-bits of said input optical serial sequence 1000. Said heaters 616, by means of a conventional stabilization and control electronic circuit, suitably regulate the temperature of said delay lines 612 for adjusting the length thereof and, thus, the phase of the output N-bits of said parallel patterns 3000.

The same result may also be obtained by using conventional piezoelectric fiber stretchers.

Optionally, suitable collimation means (not shown) may drive in free-space said N replica signals issuing from said serial to parallel converter 61 into said optical filter 62 and keep them within suitable transversal size. Such collimation means can be selected, for example, from the group comprising a bulk lens (such as a convex lens or a grin lens) and an array of micro-lenses (not shown).

According to a second embodiment shown in Fig. 5, said serial to parallel converter 61 is made of a suitable glass slab 614. The beam carrying the N-bits optical serial sequence 1000 at the glass slab 614 input is lightly tilted to exploit reflective-refractive properties thereof. Thus, by means of a predetermined number of multiple reflections, said parallel pattern 3000 of N bits is found at the output of said glass slab 614. Furthermore, a single mirror or, alternatively, N mirrors 618, placed at the input surface of the glass slab 614, avoid further refraction of said N bits at said input surface, thus preventing the input N-bits from leaving the glass slab 614 from said input surface.

At this point, said optical filter 62 and said optical lens 63 perform, at the transmission bit rate, an optical asynchronous processing of said N-bits parallel pattern 3000 to recognize whether or not said input N-bits serial sequence 1000 corresponds to said target N-bits serial sequence.

Said optical filter 62 is a phase-only filter (POF) wherein the conjugate phase information of said target N-bits serial sequence is recorded. Said POF consists, for example, of a conventional spatial light modulator (SLM), made of an electro-optical material, or a conventional phase mask made by means of optical or electron-beam lithography technology.

In case of a SLM, for example, said optical filter 62 is implemented by a liquid crystal array of N binary pixels which perform a 0 or $\pi$ phase delay on each bit of said parallel pattern 3000 according to the conjugate phase information of said target N-bits serial sequence. Said $0/\pi$ phase delay is obtained by controlling the electric potential differences applied to said liquid crystal array via an electronic control. In fact, thanks to the birefringence properties of the liquid crystal, a rotation of the plane of polarization of an incident light and, thus, a variation of the incident light phase can be carried out by applying a predetermined difference of electric potential to the liquid crystal.

Thus, the optical filter 62 can be made using a simple binary array of N pixels.

Alternatively, when said optical filter 62 is implemented by means of said phase mask, said phase delay of either 0 or $\pi$ is performed on said N-bits of said parallel pattern 3000 by a suitable refractive element having a predetermined stepped thickness profile. The required thickness is function of both the refractive index of the element and the operating wavelength.

The same result may be obtained by using a matched filter.

Said lens 63 is placed against the output of said optical filter 62 and is, for example, a symmetric convex lens having a focal length f.

According to a variant, it can also be a conventional grin lens or a diffraction lens as a conventional Fresnel lens.

Accordingly, the wavefront of the N-bits of said parallel pattern 3000 is phase delayed by said optical phase-only filter 62 and then processed by said optical lens 63 in its back focal plane thus giving an output optical intensity 2000 at the axis origin thereof.

Said output optical intensity 2000 is, thus, collected and coupled, by means of suitable collimation means (not shown), in said output optical waveguide 65 so as to be used in optional subsequent stages of processing. Numerical simulations show that, in order to maximize the optical intensity coupled in said output optical waveguide 65, the focal length f of said optical lens 63 must be much greater (for example 10 times greater) than a critical distance $Z_{coupling}$, wherein $Z_{coupling}$ is defined as:

$$Z_{coupling} = \Delta \cdot \tan\left(\frac{\pi}{2} - \frac{\lambda}{\pi\omega}\right) \qquad (1)$$

Where $\omega$ is the beam waist of the gaussian beams at the input of the device 6 and of the output beam coupled in said output optical waveguide 65, $\Delta$ is the distance between input beams (each beam representing a bit) and $\lambda$ is the wavelength. For example, for $\lambda$=1.55μm, $\omega$=4.5μm, $\Delta$=125μm, Zc equals 1.1mm and the focal length f should be greater that 11mm.

Investigating the mathematical operation performed by the device 6, the inventors represented the input N-bits parallel pattern 3000 as a sum $in(x)$ of N Dirac's delta pulses ($\delta$) which are at distance $\Delta$ each other along the x Cartesian axis and are phase modulated by the N bit values:

$$in(x) = \sum_{i=1}^{N} a_i \delta\left(x - (i - \frac{N+1}{2})\Delta\right) \qquad (2)$$

where $a_i$ are the bit weights of the input parallel pattern 3000 ($a_i = \pm 1$ for phase modulation of 0 or $\pi$). Furthermore, they represented the transfer function of the phase only filter 62 as follows:

$$\varphi_{POF} = -\angle \sum_{i=1}^{N} t_i \delta\left(x - (i - \frac{N+1}{2})\Delta\right) \qquad (3)$$

where $t_i$ (assuming values +1 or -1 for phase modulation of 0 or $\pi$) are the bit weights of the target N-bits optical serial sequence.

Therefore, the optical field issuing from the phase only filter 62 is:

$$U_1(x) = in(x) e^{j\varphi_{POF}(x)} \qquad (4)$$

$$= \sum_{i=1}^{N} a_i \delta\left(x - (i - \frac{N+1}{2})\Delta\right) \cdot t_i$$

Furthermore, since the phase only filter 62 is placed against said optical lens 63 and not in its front focal plane (see Fig. 1), said optical lens 63 performs in its back focal plane f a Fourier transform, of said optical field $U_1(x)$, with an

additional quadratic phase factor. Therefore, the device of the invention is not requested to recognize a target N-bits serial sequence by means of a proper correlation operation, as conventionally defined in mathematics, and the optical field issuing from the optical lens 63 is:

$$U_f(\xi) = \int U_1(x) \cdot e^{-j2\pi\xi x} dx \cdot e^{-j2\pi\lambda f\xi^2} \tag{5}$$

$$= \sum_{i=1}^{N} a_i t_i \int \delta(x - (i - \frac{N+1}{2}\Delta)) \cdot e^{-j2\pi\xi x} dx \cdot e^{-j2\pi\lambda f\xi^2}$$

$$= \sum_{i=1}^{N} a_i \cdot e^{-j\angle b_i} \cdot e^{-j2\pi\xi\delta(x - (i - \frac{N+1}{2})\Delta)} \cdot e^{-j2\pi\lambda f\xi^2}$$

wherein $\xi$ is the spatial frequency in the Fourier transform domain, $\lambda$ is the wavelength of the optical beam carrying the N-bits, f is the focal length of the optical lens 63, $e^{-j\angle bi} = t_i$ and they Cartesian coordinate has been considered to be zero (y=0).

Nevertheless, said quadratic phase factor has no effect on the device 6 operation because the capability of discriminating the target N-bits parallel pattern depends only on the output optical intensity 2000 at the axis origin of the back focal plane f of the optical lens 63. In fact, the value of the output optical intensity 2000 at the axis origin with a generic input serial sequence of N-bits is:

$$|U_f(0)|^2 = \left| \sum_{i=1}^{N} a_i t_i \right|^2 \tag{6}$$

while, with the target serial sequence of N-bits at the input, is:

$$|U_f(0)|^2 = \left| \sum_{i=1}^{N} t_i t_i \right|^2 = N^2 \tag{7}$$

Finally, the inventors found that the discrimination value D is represented by the following mathematical formula:

$$D = 1 - \left( \frac{\left[ \sum_{i=1}^{N} a_i t_i \right]_{MAX}}{N \sum_{i=1}^{N} t_i^2} \right)^2 = 1 - \left( \frac{N-2}{N} \right)^2 \tag{8}$$

The inventors mathematically found that the discrimination value D is independent of the shape of the bits entering the optical device 6. Thus, the discrimination value D is applicable also to an input serial sequence which is, for example, a sum of gaussian beams.

Accordingly, the device of the invention performs a predetermined phase delay on the N-bits of an input serial sequence so as to:

- converting the input N-bits serial sequence into a parallel pattern of N-bits carrying the same information as said input N-bits serial sequence;
- adjusting the phase of each bit of the parallel pattern according to the conjugate phase of the target N-bits serial sequence; and
- converting the adjusted N-bits in accordance with a Fourier transformation (except a quadratic phase factor).

In other words, the inventors have found that it is possible to compare an optical serial sequence of N-bits with a target sequence of N-bits by submitting the N-bits of an input serial sequence to

1) a first phase delay $\phi_1$ for converting said input N-bits serial sequence into a parallel pattern of N-bits; and to

2) a second phase delay $\phi_2$ obtained by adding the phase delay $\phi_{POF}$ and the phase delay $\phi_L$ according to formula (5), wherein said $\phi_{POF}$ [as defined by formula (3)] is obtained by said optical filter 62 and $\phi_L$ is performed by the optical lens 63 ($\phi_2 = \phi_{POF} + \phi_L$).

For example, referring to a conventional planoconvex optical lens, having a focal length f, $\phi_L$ will be:

$$\varphi_L = \frac{2\pi}{\lambda(n-1)} \times th(x,y) \qquad (9)$$

wherein $\lambda$ is the wavelength of the optical beam carrying the N-bits, n is the refractive index of the optical lens, and th(x,y) is defined as

$$th(x,y) = R\left[1 - \sqrt{1 - \frac{x^2 + y^2}{R^2}}\right] \qquad (10)$$

with R=(n-1)f .

According to the aforesaid mathematical formula (8), the discrimination value D achieved by the device 6 of the invention for sequences of 8 bit (N=8) is of about 43.75%, that is the same as for a Vander Lugt correlator having phase modulated input bits and matched filter However, the device 6 of the invention is simpler to implement (i.e. lower costs) and more compact.

Furthermore, the device of the invention can be even more compact than that of Fig. 1. In fact, the inventors perceived that the relevant factor is a predetermined phase delay ($\phi_1 + \phi_2 = \phi_1 + \phi_{POF} + \phi_L$) on the N-bits of an input serial sequence. Thus, one or more of said serial to parallel converter 61, said optical filter 62 and said optical lens 63 can be replaced by any other optical element capable of performing the same phase delay. For example, the aforesaid spatial light modulator (SLM) or the above mentioned phase mask can be used also for performing the same phase delay as said optical filter 62 ($\phi_{POF}$) and said optical lens 63 ($\phi_L$), that is the phase delay according to formula (5).

Alternatively, the heaters 616 (as well as the piezoelectric fiber stretchers) of the serial to parallel converter 61 can be suitably adjusted so as to perform substantially the same phase delay as said optical filter 62 ($\phi_{POF}$) and, optionally, as said optical lens 63 ($\phi_L$) as well. For example, the heaters will be adjusted in a conventional way so as to cause at each fiber output an optical field value according to formula (5) wherein the value of (x) corresponds to a preselected point of the fiber output. For example, the point ($x_c$) corresponding to the fiber center.

Furthermore, the same effect can be achieved also by means of the glass slab 614 shown in Fig. 5 simply by placing on its output surface a preselected variable thickness layer 619 (not shown) made of a suitable refractive material.

According to another embodiment of the invention, the optical device 6 may be implemented by integrated optics. Preferably, it may be implemented by means of a single optical integrated circuit 700. For example, as shown in Fig. 10, the integrated circuit 700 comprises a serial to parallel converter 701 made of a single 1x8 beam splitter 702 (consisting, for example, of a cascade of 1x2 waveguide splitters) and of optical waveguides 703 each having a suitable length, as described above. Preferably, said serial to parallel converter 701 further comprises heaters of the aforementioned type. Furthermore, the integrated circuit 700 comprises an optical waveguide 704 having a portion 705 with a refractive index which may be suitably modulated so as to perform the same phase delay as said optical phase-only filter 62 and said optical lens 63. For example, the refractive index may be modulated by illumination of a germanium-doped silica optical waveguide with an intense UV light through a suitably designed opening in an otherwise opaque mask, as disclosed by J. Albert et al., "Planar Fresnel lens photoimprinted in a germanium-doped silica optical waveguide", Optics Letters, Vol. 20, No. 10, pages 1136-1138, May (1995). Alternatively, the refractive index may be modulated by etching an optical waveguide by means of an electron-beam lithography as disclosed by M. Gibbon et al., "Optical Performance of Integrated 1.5µm grating Wavelength-Demultiplexer on InP-based waveguide", Electronics Letters, Vol. 25, No. 21, pages 1441-1442, October (1989).

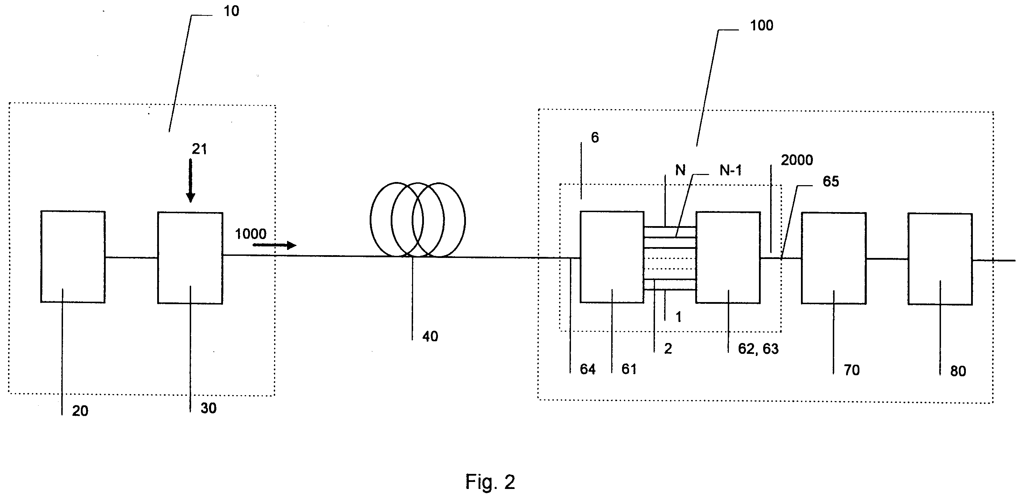

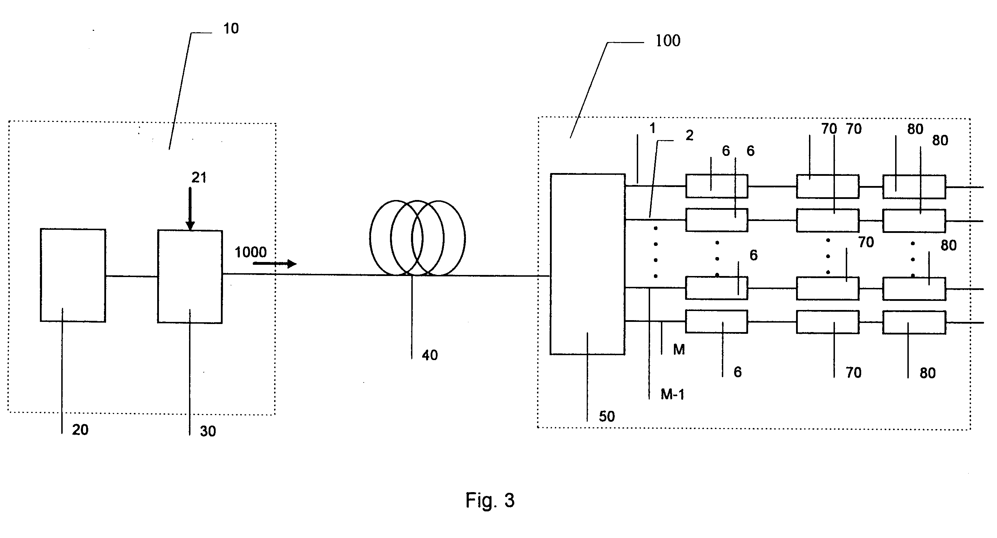

The optical device 6 may be used in an optical transmission system wherein it is necessary to recognize a target N-bits optical sequence (Fig. 2) or M target N-bits optical sequences (Fig. 3) from a communication optical signal. For example, it can be used for recognizing a predetermined address or an "header in the known Asynchronous Transfer Mode (ATM) optical networks.

The optical transmission system shown in Fig. 2 comprises a transmitter 10 having a source 20 for an optical signal 1000 at a predetermined wavelength and a phase modulator 30 for phase modulating said optical signal 1000. At the output of said transmitter 10 there is an optical waveguide 40 which has an input end connected thereto and an output end connected to a receiver 100. Said receiver 100 comprises an optical device 6 according to the invention, a photo-detector 70, a threshold circuit 80 and, optionally, subsequent processing stages (not shown) as well.

Said source 20 is a laser source emitting at a wavelength of a telecommunication signal as, for example, in the range of about 1300-1600nm. Said phase modulator 30 is a conventional optical modulator made, for example, of lithium niobate which performs a binary phase modulation of the optical signal 1000 according to a piloting electrical digital signal 21 carrying the digital information to be transmitted. For example, said phase modulator 30 associates to the optical signal 1000 a phase:

- $\phi=0$ when the digital bit of said electrical signal is 0; while
- $\phi=\pi$ when the digital bit of said electrical signal is 1.

Said optical transmission waveguide 40 is an optical single mode fiber at the transmission wavelength. Said photo-detector 70 is, for example, a conventional InGaAs photo-diode PIN like the ETX75 FJ SRL model marketed by EPITAXX OPTOELECTRONICS DEVICES, 7 Graphics Drive, West Trenton, NJ, USA and said threshold circuit 80 consists, for example, of a conventional peak detector circuit and a conventional comparison circuit and its output digital signal level depends on whether the input signal level is higher or lower than a predetermined threshold level.

In the receiver 100, said device 6 according to the invention optically processes, as described above, input N-bits serial sequences of said optical signal 1000. The output optical intensity 2000 issuing therefrom is then transformed into an electrical signal by said photo-detector 70 and then processed by said threshold circuit 80 to establish whether or not said input N-bits serial sequences correspond to said target N-bits serial sequence.

In case of a wavelength division multiplexed (WDM) system, in which two or more signals, having different wavelengths, are all transmitted in said optical transmission waveguide 40, the receiver 100 will have one device 6 of the invention, one photo-detector 70 and one threshold circuit 80 for each transmitted signal which will be conventionally demultiplexed at the input of the devices 6.

The optical transmission system shown in Fig. 3 differs from that one of Fig. 2 because of the receiver 100. In fact, said receiver 100 comprises at its input a 1xM beam splitter 50, of the type described above, which splits said optical signal 1000, issuing from said optical waveguide 40, into M replica signals having substantially the same intensity. Thus, M devices 6 of the invention, M photodetectors 70 and M threshold circuits 80 process said M replica signals in order to recognize whether or not an input N-bits serial sequence from said optical signal 1000 is equal to one of said M target serial sequences of N-bits.

Furthermore, in case of a WDM system, the receiver 100 will have M devices 6 of the invention, M photo-detectors 70 and M threshold circuits 80 for each transmitted signal having its characterizing wavelength.

## Claims

1. An optical device (6) for processing an input optical serial sequence (1000) of phase-modulated N-bits having a predetermined one-bit time slot in order to compare said input optical serial sequence (1000) of phase-modulated N-bits with a predetermined sequence of N-bits, said device comprising

    a) input means (64) for said input optical serial sequence (1000) of phase-modulated N-bits;
    b) a first optical element (61; 701) for converting said input optical serial sequence (1000) of phase-modulated N-bits into an optical parallel pattern (3000) of phase-modulated N-bits carrying the same information as said input optical serial sequence (1000) of phase-modulated N-bits;
    c) a second optical element (616; 619; 62; 704) capable of causing a phase delay of at least one bit of said optical parallel pattern (3000), said phase delay having a preselected value depending on said predetermined N-bits sequence.

2. An optical device (6) according to claim 1, characterized in that said second optical element (616; 619; 62; 704) causes said phase delay having said preselected value so as to:

    - adjust the phase of said at least one bit of said optical parallel pattern (3000) according to the conjugate phase of the corresponding bit of said predetermined sequence of N-bits; and
    - process the N-bits of said optical parallel pattern (3000) substantially in accordance with a Fourier transformation.

3. An optical device (6) according to any of claim 1 to 2, characterized in that said second optical element (616; 619;

62; 704) is asynchronous.

4.  An optical device (6) according to any of claims 1 to 3, characterized in that said second optical element (616; 619; 62; 704) is a spatial light modulator (62).

5.  An optical device (6) according to any of claims 1 to 3, characterized in that said second optical element (616; 619; 62; 704) is a phase mask (62).

6.  An optical device (6) according to any of claims 1 to 3, characterized in that said second optical element (616; 619; 62; 704) is a waveguide (704) having a predetermined portion (705) made of a suitable material having a refractive index suitably modulated so as to perform on said at least one bit of said optical parallel pattern (3000) said phase delay having a preselected value.

7.  An optical device (6) according to claim 1, characterized in that said second optical element (616; 619; 62; 704) adjusts the phase of said at least one bit of said optical parallel pattern (3000) according to the conjugate phase of the corresponding bit of said predetermined sequence of N-bits and in that said optical device (6) further comprises a third optical element (63) for processing the N-bits of said optical parallel pattern (3000) substantially in accordance with a Fourier transformation.

8.  An optical device (6) according to claim 7, characterized in that said third optical element (63) consists of an optical lens having a preselected focal length.

9.  An optical device (6) according to claim 7 or 8, characterized in that said second optical element (616; 619; 62; 704) is a phase-only filter.

10. An optical device (6) according to claim 8, characterized in that the distance between said second optical element (616; 619; 62; 704) and said third optical element (63) is lower than the focal length of said optical lens.

11. An optical device (6) according to any of claims 1 to 10, characterized in that said second optical element (616; 619; 62; 704) is placed substantially contiguous to said first optical element (61; 701).

12. An optical device (6) according to any of claims 1 to 11, characterized in that it further comprises output means (65) for an output optical signal having an intensity level depending on the result of the comparison between said input optical serial sequence (1000) of phase-modulated N-bits with said predetermined sequence of N-bits.

13. An optical device (6) according to claim 12, characterized in that said output means (65) comprise an optical waveguide.

14. An optical device (6) according to any of claims 1 to 13, characterized in that said input means (64) comprise an optical waveguide.

15. An optical device (6) according to any of claims 1 to 14, characterized in that said first optical element (61; 701) comprises a 1xN beam splitter (610) to clone said input serial sequence (1000) of N-bits into N equal replica signals.

16. An optical device (6) according to claim 15, characterized in that said first optical element (61; 701) further comprises a plurality of optical delay lines (612) having selected lengths for delaying each of said N replica signals according to a predetermined time slot.

17. An optical device (6) according to claim 1 to 14, characterized in that said first optical element (61; 701) comprises a glass slab (614).

18. An optical telecommunication system comprising:

    -   a first apparatus (10) for transmitting at least one optical digital signal comprising at least one optical serial sequence (1000) of N-bits,
    -   an optical transmission line (4),
    -   a second apparatus (100) for receiving said at least one optical serial sequence (1000) of N-bits,

- a processing module (7, 8) capable of transmitting a result of said comparison,

said second apparatus (100) comprising at least one optical device (6) which, in turn, comprises

i. a first optical element (61; 701) for converting said at least one optical serial sequence (1000) of N-bits into an optical parallel pattern (3000) of N-bits carrying the same information as said at least one optical serial sequence (1000) of N-bits; and

ii. a second optical element (616; 619; 62; 704) capable of causing a phase delay on at least one bit of said at least one optical serial sequence (1000), said phase delay having a preselected value depending on a predetermined sequence of N-bits so as to compare said at least one optical serial sequence (1000) of N-bits with said predetermined sequence of N-bits.

19. An optical telecommunication according to claim 18, characterized in that said first apparatus (10) comprises a phase modulator(3) for phase modulating said at least one optical serial sequence (1000) of N-bits.

20. An optical telecommunication according to claim 18 or 19, characterized in that said preselected value of said phase delay caused by said second optical element (616; 619; 62; 704) is selected so as to:

- adjust the phase of said at least one bit of said optical parallel pattern (3000) according to the conjugate phase of the corresponding bit of said predetermined sequence of N-bits; and
- process the N-bits of said optical parallel pattern (3000) substantially in accordance with a Fourier transformation.

21. An optical telecommunication according to any of claims 18 to 20, characterized in that said processing module (7, 8) comprises a photo-detector (7).

22. An optical telecommunication according to claim 21, characterized in that said processing module (7, 8) further comprises a threshold circuit (8).

23. An optical telecommunication according to any of claims 18 to 22, characterized in that said second apparatus (100) comprises M optical devices (6) for comparing said at least one serial sequence (1000) of N-bits with M predetermined serial sequences of N-bits.

24. An optical telecommunication system according to any of claim 18 to 23, characterized in that said first apparatus (10) transmits a plurality of optical digital signals, each having a predetermined wavelength and consisting of at least one serial sequence of N-bits.

25. An optical telecommunication system according to claim 24, characterized in that said second apparatus (100) comprises at least one optical device (6) for each of said plurality of optical digital signals for comparing each of said at least one serial sequence of N-bits with a predetermined serial sequence of N-bits.

26. An optical telecommunication system according to any of claim 18 to 25, characterized in that said optical transmission line (4) is an optical cable.

27. A method for optically comparing an optical serial sequence (1000) of phase modulated N-bits with a predetermined sequence of N-bits comprising the steps of:

a) converting said optical serial sequence (1000) of phase modulated N-bits into an optical parallel pattern (3000) of phase modulated N-bits carrying the same information as said optical serial sequence (1000) of N-bits;

b) delaying the phase of at least one bit of said optical parallel pattern (3000) of phase modulated N-bits according to a phase delay having a preselected value depending on said predetermined sequence of N-bits.

28. A method according to claim 27, characterized in that the step b) is performed by:

i. adjusting the phase of at least one bit of said optical parallel pattern (3000) of N-bits according to the conjugate phase of the corresponding bit of said predetermined sequence of N-bits; and

ii. processing the N-bits of said optical parallel pattern (3000) substantially in accordance with a Fourier transformation.

**29.** A method according to claim 27 or 28, characterized in that it further comprises the steps c) of outputting an output optical signal having an intensity level depending on the result of the comparison between said input optical serial sequence (1000) of phase-modulated N-bits with said predetermined sequence of N-bits.

**30.** A method according to claim 29, characterized in that it further comprises the steps d) of processing said output optical signal for transmitting a result of the comparison between said optical serial sequence (1000) of N-bits with said predetermined sequence of N-bits.

**31.** A method according to claim 30, characterized in that the step d) comprises a comparison of the intensity of said output optical signal with a predetermined threshold intensity.

**32.** A method according to any of claims 27 to 31, characterized in that the step b) is performed asynchronously.

Fig.1

100

6

2000

65

N

N-1

1

2

80

70

62, 63

61

64

10

21

1000

40

30

20

Fig. 2

Fig. 3

Fig. 4

Fig. 5

Fig. 6

Fig. 7

Fig. 8

Fig. 9

Fig. 10

**European Patent Office**

**EUROPEAN SEARCH REPORT**

Application Number

EP 99 20 2313

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 4 604 707 A (YAMASHITA TSUKASA ET AL) 5 August 1986 (1986-08-05) * abstract * | 1,18,27 | G06E1/02 |
| A | EP 0 346 896 A (FUJITSU LTD) 20 December 1989 (1989-12-20) * abstract * | 1,18,27 | |
| A | FORD ET AL: "Matrix-tensor multiplication etc..." SPIE PROCEEDINGS, vol. 1151, August 1989 (1989-08), pages 220-230, XP002092063 * abstract * | 1,18,27 | |
| A | MAROM ET AL: "Analysis of spatial-temporal etc..." APPLIED OPTICS, vol. 37, no. 14, 10 May 1998 (1998-05-10), pages 2858-2868, XP002092064 * abstract * | 1,18,27 | TECHNICAL FIELDS SEARCHED (Int.Cl.7) G06E |

The present search report has been drawn up for all claims

| Place of search | Date of completion of the search | Examiner |
|---|---|---|
| THE HAGUE | 5 October 1999 | Cohen, B |

## ANNEX TO THE EUROPEAN SEARCH REPORT
## ON EUROPEAN PATENT APPLICATION NO.

EP 99 20 2313

This annex lists the patent family members relating to the patent documents cited in the above-mentioned European search report.
The members are as contained in the European Patent Office EDP file on
The European Patent Office is in no way liable for these particulars which are merely given for the purpose of information.

05-10-1999

| Patent document cited in search report | | Publication date | Patent family member(s) | | Publication date |
|---|---|---|---|---|---|
| US 4604707 | A | 05-08-1986 | JP | 1724804 C | 24-12-1992 |
| | | | JP | 4008964 B | 18-02-1992 |
| | | | JP | 58156212 A | 17-09-1983 |
| | | | JP | 58162929 A | 27-09-1983 |
| | | | JP | 1713638 C | 27-11-1992 |
| | | | JP | 3077496 B | 10-12-1991 |
| | | | JP | 58162930 A | 27-09-1983 |
| EP 0346896 | A | 20-12-1989 | JP | 1317026 A | 21-12-1989 |
| | | | JP | 2032012 C | 19-03-1996 |
| | | | JP | 7073219 B | 02-08-1995 |
| | | | CA | 1304845 A | 07-07-1992 |
| | | | DE | 68911761 D | 10-02-1994 |
| | | | DE | 68911761 T | 09-06-1994 |
| | | | US | 4965797 A | 23-10-1990 |

EPO FORM P0459

For more details about this annex : see Official Journal of the European Patent Office, No. 12/82